**Europäisches Patentamt**

**European Patent Office**

**Office européen des brevets**

(19)

(11) Publication number : **0 388 986 B1**

# EUROPEAN PATENT SPECIFICATION

(12)

(45) Date of publication of patent specification :
08.11.95 Bulletin 95/45

(51) Int. Cl.[6] : **G02F 1/136, H01L 21/84, H01L 29/94**

(21) Application number : 90105597.0

(22) Date of filing : 23.03.90

(54) **Active matrix type liquid crystal display device and method of manufacturing it.**

(30) Priority : 23.03.89 JP 71117/89
12.04.89 JP 92458/89
14.04.89 JP 95634/89
20.04.89 JP 100685/89
24.04.89 JP 103719/89
25.04.89 JP 105043/89
25.04.89 JP 105044/89
25.04.89 JP 105045/89
25.04.89 JP 105046/89
26.04.89 JP 106428/89
09.05.89 JP 115572/89
08.11.89 JP 290525/89

(43) Date of publication of application :
26.09.90 Bulletin 90/39

(45) Publication of the grant of the patent :
08.11.95 Bulletin 95/45

(84) Designated Contracting States :
DE FR GB

(56) References cited :
GB-A- 2 091 468
JP-A- 0 155 540

(56) References cited :
JOURNAL OF THE ELECTROCHEMICAL SOCI-
ETY, vol. 113, no. 6, June 1966, pp. 542-547 ; D.
GERSTENBERG : "Properties of anodic films
formed on reactively sputtered tantalum"
PATENT ABSTRACTS OF JAPAN, vol. 11, no.
253 (P-606)[2700], 18th August 1987 ; & JP-A-62
59 927
SID INTERNATIONAL SYMPOSIUM, DIGEST
OF TECHNICAL PAPERS, May 1982, pp.
248-249 ; R.W. STREATER et al.: "20.6/3:40
P.M.: MIM addressed LCDs status and pros-
pects"

(73) Proprietor : SEIKO EPSON CORPORATION
4-1, Nishishinjuku 2-chome
Shinjuku-ku Tokyo-to (JP)

(72) Inventor : Suzuki, Katsumi, c/o Seiko Epson
Corporation
3-5, Owa 3-chome,
Suwa-shi
Nagano-ken (JP)
Inventor : Nishikawa, Mitsutaka, c/o Seiko
Epson Corporation
3-5, Owa 3-chome,
Suwa-shi
Nagano-ken (JP)

(74) Representative : Hoffmann, Eckart, Dipl.-Ing. et
al
Patentanwalt
Bahnhofstrasse 103
D-82166 Gräfelfing (DE)

EP 0 388 986 B1

## Description

The present invention concerns an active matrix type liquid crystal display device and a method of manufacturing it.

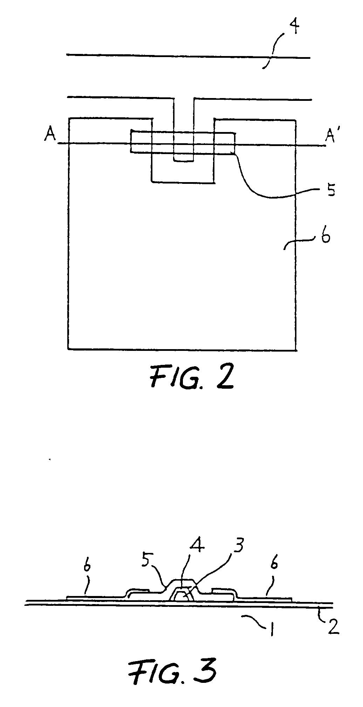

The image display methods of liquid crystal displays at present are largely classified into a simple matrix system and an active matrix system. In the simple matrix system, a liquid crystal layer is put between two sets of stripe electrode groups disposed in perpendicular to each other and the stripe electrodes are respectively connected with driving circuits. Since the structure is simple, this system can be attained at a reduced cost but involves the problem of low contrast due to crosstalk. As compared with the simple matrix system in the active matrix system, a switch is disposed to each of the picture elements to maintain the voltage written into the picture elements. Since the voltage written upon selection can be maintained even in time divisional driving, the display capacity can be increased and the property with regard to the image quality such as contrast is satisfactory, but the structure is complicate making the manufacturing cost higher. For instance, with TFT (Thin Film Transistor) active elements, it is difficult to improve the yield because of the necessity of stacking 5 - 6 layers of thin films by using 5 or more photomasks. In view of the above, 2-terminal devices that can be manufactured at an improved yield and a reduced cost have been contemplated to be used as active devices. A typical 2-terminal device is a MIM (Metal Insulator Metal) device, the general material and structure of which are shown in Figs. 2 and 3, as an upper plan view and a cross sectional view of the device, respectively. While TaOx prepared by anodizing a lower electrode has been used for the device insulation film, since the relative dielectric constant thereof is about 30, the device capacitance is as large as 0.1 pF under general conditions of a device size of 5 $\mu$m x 4 $\mu$m and an anodized film thickness of 60 nm, which is as large as more than $\frac{1}{2}$ of the liquid crystal capacitance of one picture element.

However, since the capacitance ratio between the liquid crystal and the device is 2 or less than 2 (usually about 1.6) upon applying a voltage to the liquid crystal panel, this involves a problem that no sufficient voltage is applied to the MIM device to worsen the switching characteristic. A study has been made for overcoming the problem as described below.

(1) Further size reduction of the device: for example, a device sized 3 $\mu$m x 3 $\mu$m.

(2) Increase of insulation film thickness: for instance, an anodized insulation film of 100 nm thickness.

However, the production yield of the device substrate has been extremely worsened in the approach (1). Although the device capacitance can be reduced, the non-linear coefficient ($\beta$ value) of the current-voltage characteristic of the device is worsened and the merit is not so much in the approach (2).

In addition, the non-linear coefficient ($\beta$ value) of the I-V characteristic in the conventional device is less than 3.4 even at room temperature, which is further reduced to about 2.5 at a higher temperature of 60°C. Further, the resistance value R(3V) of the MIM device in a low voltage range is as low as about $1 \times 10^{11}$ ohm at a normal temperature and about $5 \times 10^9$ ohm at 60°C.

Further, a redundant design such as picture element division has been adopted also in TFT devices in recent years, and the production yield has been improved. However, picture element division is still impossible for MIM devices due to the reason of the device capacitance.

As has been described above, there has been a problem that the display quality of a MIM panel is still inferior up to now to that of a TFT panel due to the device capacitance, $\beta$ value, device resistance in the low voltage range and the temperature characteristic thereof. Further, there also exists a problem that there is no substantial difference between the production cost of the MIM panel and that of the TFT panel whose production yield has been increased by the redundant design.

The document GB-A-2 091 468 discloses an active matrix type liquid crystal display device comprising a plurality of row electrodes disposed on a first substrate, a plurality of column electrodes intersecting said row electrodes and disposed on an opposed second substrate, a plurality of MIM elements formed on one of said substrates each in a respective one of picture element portions defined in a matrix-like pattern at the intersections between both of said electrodes, in which a liquid crystal sealed between said substrates is electrically driven for display. For manufacturing such display device the document discloses a method which comprises a first step of preparing a glass substrate having formed thereon an underlying first insulation film made of $Ta_2O_5$, a second step of applying RF sputtering to form a Ta film on an underlying insulation film in a nitrogen-containing atmosphere, a third step of pattern etching the Ta film formed in the second step to form a lower electrode, a fourth step of anodizing the pattern etched Ta film into a second insulation film (insulator), a fifth step of forming a metal film on the second insulation film, a sixth step of pattern etching the metal film to prepare an upper electrode, a seventh step of forming an ITO film after the sixth step, and an eighth step of etching the ITO film into a picture element electrode.

It is an object of the present invention to solve the foregoing problems and to provide an active matrix type liquid crystal display device capable of obtaining an image quality comparable with or superior to that of a TFT panel, in addition to the inherent merit of a 2-terminal device in the active matrix system, that is, reduced cost and higher production yield.

The foregoing object of the present invention can be attained by an active matrix type liquid crystal display device as claimed in claim 1 and a method of manufacturing the active matrix type liquid crystal display device as claimed in claim 19, respectively.

Specific embodiments of the invention are subject of the dependent claims.

These and other objects, as well as advantageous features of the present invention will become apparent by reading the following description referring to preferred embodiments of the present invention in conjunction with the accompanying drawings, wherein

Fig. 1        is a process chart showing a basic manufacturing process of the present invention and cross sectional views of the substrate corresponding thereto;

Fig. 2        is a top plan view of the MIM device;

Fig. 3        is a cross sectional view taken along line A-A' of Fig. 2;

Fig. 4        is a graph showing a relationship between the ratio of the liquid crystal capacitance and the device capacitance, and the panel contrast, as well as illustrating the crystal structure and the resistivity of the lower electrode Ta corresponding to the capacitance ratio;

Fig. 5        is a graph showing a relationship between the relative dielectric constant of the insulator and the temperature characteristic of the contrast;

Fig. 6        is a graph showing a relationship between the temperature characteristic of the device $\beta$ value and the relative dielectric constant of the insulator;

Fig. 7        is a graph showing a relationship between the temperature characteristic of the device resistance upon applying 3 V and the relative dielectric constant of the insulator;

Fig. 8        is a structural view of a panel using a color filter with overlying electrodes;

Fig. 9        is a structural view of a panel using a color filter with underlying electrodes;

Fig. 10       is a view showing a relationship between the N-addition method to various kinds of insulators and $\varepsilon$ stability, in which a gas mixture cylinder for Ar-$N_2$ controlled to an optional concentration is used in (1), N-added Ta target is used in (2) and Ar and $N_2$ are separately introduced into a sputter chamber by a mass flow meter in (3);

Fig. 11       is a graph showing a relationship between the Si addition amount to the insulator and the $\varepsilon$ value;

Fig. 12       is a graph for Example-2 showing a relationship between the N addition amount to the underlying insulation film TaOx and the etching rate of the underlying insulation film, as well as the device characteristic, in which (1) shows the underlying layer formed by reactive sputtering and (2) shows the underlying layer formed by thermal oxidation;

Fig. 13       is a graph showing a stable device characteristic and an instable device characteristic;

Fig. 14       is a graph showing the concentration of the water content in the liquid crystal panel cell and the I-V device characteristic;

Fig. 15       is a graph showing a relationship between the N concentration in the TaOx film and the refractive index of the TaOx film and the reflectivity of the TaOX film; and

Fig. 16       is an upper plan view of MIM devices illustrating Example-3 in which the device capacitance is reduced to $\frac{1}{2}$ of the usual device and redundant design is conducted by picture element division.

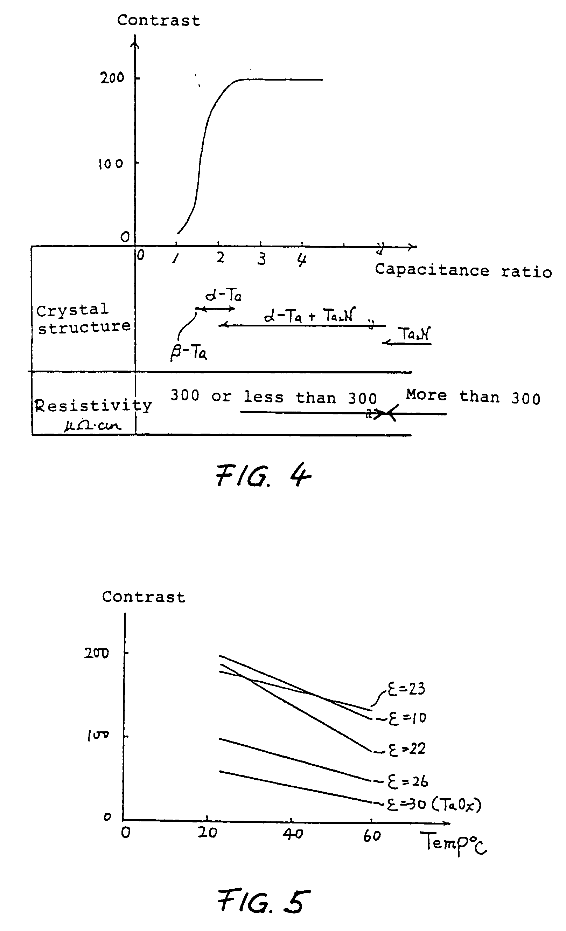

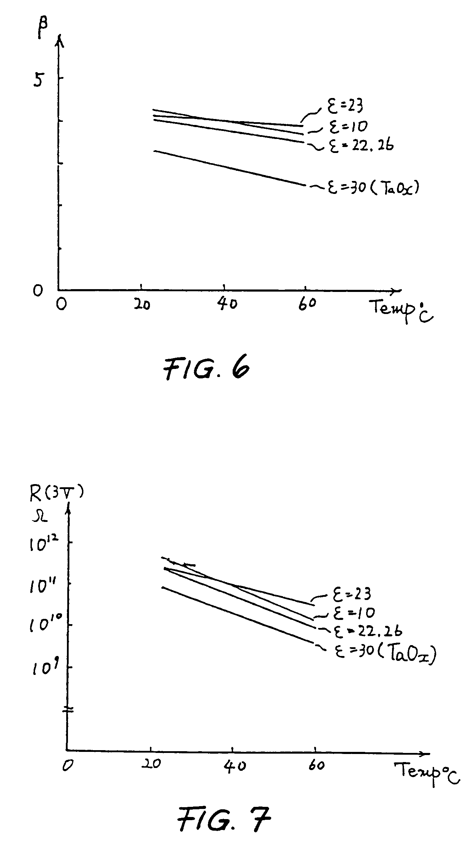

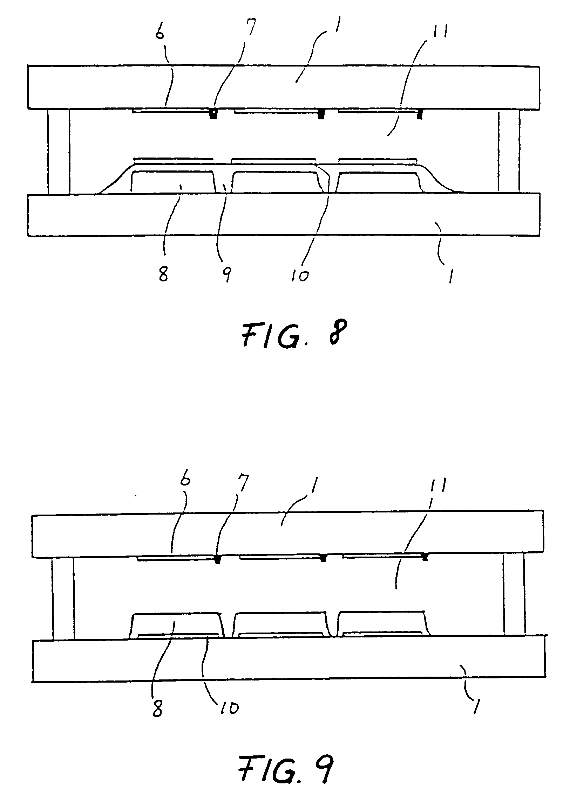

Fig. 4 shows the relationship between the normally white mode displaying contrast and the capacitance ratio between the liquid crystal in the picture element portion and the device. By varying the amount of N added to Ta forming the lower electrode, the $\varepsilon$ value of the anodized film of TaOx is changed to thereby vary the capacitance ratio. The Figure also shows the crystal structure and the resistivity of the lower electrode Ta in this case. Further, Fig. 5 shows the temperature characteristic of the contrast for several values of $\varepsilon$. Fig. 6 shows the temperature characteristic of $\beta$ with $\varepsilon$ as the parameter. Fig. 7 shows the temperature characteristic of the device resistance R(3V) upon applying 3V for several values of $\varepsilon$. As can be seen from Fig. 5, if $\varepsilon$ is 22 or less than 22, a contrast of 85 can be secured even at 60°C. Although the contrast of the TFT panel is generally higher than 100, since a contrast of higher than 70 - 80 can not clearly be distinguished by human eyes, a contrast comparable with that of a TFT panel can be obtained if $\varepsilon$ is 22 or less than 22. Further, panel contrast is poor at 60°C for $\varepsilon$ = 26 although the values of $\beta$ and R(3V) are satisfactory, perhaps because the capacitance ratio is as low as 1.9. Although the contrast is much improved even at a value of $\varepsilon$ = 23, which may be attributable to the good temperature characteristic of R(3V), $\beta$ value, this is a data obtained only when applying sputtering by a sputtering device 50B manufactured by Tokuda Seisakusho. The condition capable of obtaining a contrast comparable with that of a TFT panel was: $\varepsilon \leqq 22$ when using a sputtering device 4ES manufactured by the above-mentioned company and 53OH manufactured by Nichiden Anerba. In view of the above, it is considered that a contrast comparable with that of a TFT panel can be obtained when $\varepsilon \leqq 22$ and the capacitance ratio is greater than 2. However, sufficient effect for the improvement of the contrast may be obtained even if such conditions are not satisfied (for example *22 < ε < 30*). Thus, a redundant design of bisecting a picture element is possible if $\varepsilon \leq 10$. In addition, since the capacitance ratio between the divided picture element and the device can be made greater than 2, a contrast comparable with that of a TFT panel can be obtained. Alternatively, if a contrast of the same level as that of the conventional MIM panel is allowed, a one inch panel with 50,000 picture elements can be obtained, which is applicable to view finders, etc. that has been considered impossible so far.

Figs. 8 and 9 show typical panel structures for normally white mode display and black mode display, respectively. In Fig. 8 and 9, 1 are substrates, 6 are picture element electrodes, 7 are MIM devices, 8 are color filter layers, 9 is a layer for achieving a flat surface above the color filter layers and 10 are ITO electrodes.

Upon applying a voltage to the liquid crystal 11 in Fig. 9, a voltage drop is caused due to the color filter layer 8 and the apparent capacitance of the liquid crystal is reduced due to the capacitance of the color filter layer failing to obtain a desired capacitance ratio. With the reason described above, a normally black mode display capable of obtaining a contrast of about 40 at a relatively lower voltage driving than the normally white mode display is selected. The normally black mode display is simple in the panel structure but involves a drawback that the contrast is lower and the tone is poor as compared with the normally white mode display. On the other hand, the normally white mode display generally has satisfactory tone and higher contrast, but it requires higher driving voltage than the normally black mode display for obtaining high contrast. However, since an IC capable of normally white mode display with a panel structure of poor efficiency as shown in Fig. 9 is not available at present, a panel structure having a color filter with overlying electrodes 10 as in Fig. 8 has to be adopted.

Further, a MIM panel for normally white mode display using the color filters can provide high image quality at a normal temperature, but it is exposed to high temperature due to the heat of back light, etc. during long time driving to remarkably reduce the contrast.

However, a high contrast from low temperature to high temperature can now be obtained even with a normally white mode display as shown in Fig. 4 by setting the following relationship:

$$C_{CF} \times C_{LC}/((C_{CF} + C_{LC}) \times C_{MIM}) > 2$$

and making the relative dielectric constant ε of the insulator to less than *30*. Further, an improved effect with respect to the contrast and the temperature characteristic has also been recognized even with normally black mode display.

Upon driving liquid crystals, if the liquid crystal contains much water content, Cr of the upper electrode in the MIM device undergoes electrolysis from a micro point of view to remarkably deteriorate the image quality due to the abnormality of device characteristic. In particular, in a case where the surface unevenness of the insulator is increased due to the addition of other elements to the device insulator, since absorption of water content tends to be increased thereby causing deterioration in the image quality, it is necessary to apply severe control for the concentration of water content in the cell.

Any of other elements can be added to the device insulator so long as it can lower the relative dielectric constant of the insulator and improve the device characteristic such as the β value, the temperature characteristic of the β value, R(3V), etc. Among all, those elements having remarkable effects are preferred such as Be, B, C, N, Mg, Al, Si, S, Ca, V, Cr, Mn, Fe, Co, Ni, Cu, Zn, Sr, Y, Cd, Sn, Ba, Pb, La, Ce, Nd, Sm, Eu, Gd, Dy, Ho, Er, Tm, Yb and Lu. In particular, since the lower electrode Ta is patterned by chemical dry etching of $CF_4 + O_2$ at present, Be, C, N, Mg, Al, Si and Cr which can be etched simultaneously are preferred.

Any of oxides, nitrides, oxynitrides can be added to the insulator so long as it can reduce the relative dielectric constant of the insulator thereby improving the β value, the temperature characteristic of the β value, R(3V) and like other device characteristics. Among all, those having remarkable effects are preferred such as oxides, nitrides and oxynitrides of Be, Mg, Al, Si, Cr, Mn, Fe, Co, Ni, Cu, Sr, Y, Sn, Ba, La, Ce, Nd, Sm, Eu, Gd, Dy, Ho, Er, Tm, Yb and Lu. In particular, Be, Mg, Al, Si and Cr which can be etched simultaneously are particularly preferred.

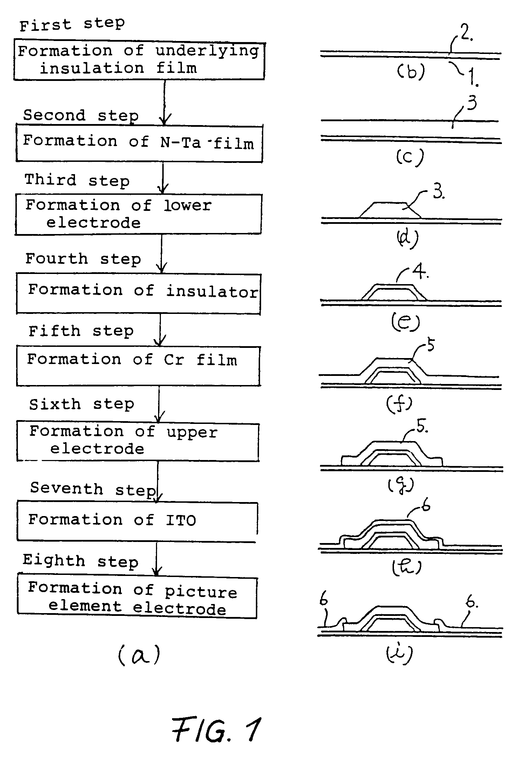

The underlying insulation film (2 in Fig. 1(b)) is used with an aim of improving the close bondability of the MIM device to the substrate thereby increasing the insulation destruction voltage of the device. Further, in a case of adding other elements to the device insulator, an effect of not exposing the substrate upon dry etching of the lower electrode is also important. That is, if the substrate is dry etched, micro cracks are formed tending to increase the absorption of the water content and causing abnormality of the device characteristics as described above. Then, any of materials having such an effect can be used and preferred are those having particularly remarkable effect such as oxides, nitrides and oxynitrides of Be, Mg, Sc, Ti, Cr, Mn, Fe, Co, Ni, Cu, Sr, Y, Zn, Mo, Sn, Hf, Ta, W, La, Ce, Pr, Nd, Sm, Eu, Gd, Dy, Ho, Er, Tm, Yb and Lu. Further, upon forming the device upper electrode, disconnection may possibly be caused to the upper electrode at the end face of the device. This is caused due to not-appropriate taper at the end face of the device and a similar phenomenon is also caused if the underlying insulation film is not etched or, on the contrary, if it is excessively etched upon etching the lower electrode. Accordingly, those properly etched by $CF_4 + O_2$ such as oxides, nitrides and oxynitrides of Be, Mg, Al, Si, Cr and Ta are particularly preferred.

If the concentration of N added to TaOx is less than 5 at%, there is no effect of improving the device characteristics such as a reduction of $\varepsilon$ and an increase of $\beta$. On the contrary, if it is more than 25 at%, although the panel image quality can be further improved, since the instability of the device characteristic is increased, it requires severe control such as for the water content in the liquid crystal cell. Accordingly, an appropriate addition amount of N is from 5 to 25 at%.

Further, in the case of forming the insulator by adding N and oxidizing the lower electrode, if the N concentration in the lower electrode is not within 5 - 45 at%, the N-concentration in the insulator is not within a range of 5 to 25 at% after oxidization. In addition, the resistivity of the Ta lower electrode becomes greater than 300 $\mu\Omega$cm, thereby giving an effect on the driving of the liquid crystal and the contrast is difficult to be improved.

When the N concentration in the lower electrode is within a range from 5 to 45 at%, the resistivity of the lower electrode Ta is within a range from 60 to 300 $\mu\Omega$cm (the lowest resistivity value for Ta is 60 $\mu\Omega$cm for $\alpha$-Ta). Further, the crystal structure of Ta in this case is $\alpha$-Ta or a mixed state of $\alpha$-Ta and Ta$_2$N (refer to Fig. 4).

The present invention will be described more specifically referring to examples.

Example-1

Basic manufacturing steps for a MIM device according to the present invention are explained referring to Fig. 1.

Fig. 1(a) is a flow chart illustrating the fabrication steps, while Fig. 1(b) - (i) illustrate the cross sections of the MIM device corresponding to the flow chart.

In Fig. 1(b), an underlying insulation film 2 is formed on a substrate 1. In this case, the substrate is made of Ba borosilicate glass and the underlying insulation film is prepared by sputtering N-added Ta on the substrate to a thickness of 40 nm, which is then thermally oxidized into a transparent TaOx film to complete the underlying insulation film. Then, in Fig. 1(c), an N-added Ta film is sputtered over the underlying insulation film 2 to a thickness of 350 nm, to which a resist (not illustrated) is applied by coating to a predetermined pattern and which is then patterned by chemical dry etching in CF$_4$+O$_2$ gas into the shape of the lower electrode 3 as shown in Fig. 1(d). After removing the resist, the lower electrode is anodized in an aqueous solution of citric acid as shown in Fig. 1(e) to form a TaOx insulation film of 60 nm, that is, an insulator 4.

Then, Cr is sputtered to the upper surface as shown in Fig. 1(f) and, after forming a resist (not illustrated) to a predetermined shape, etching is applied to form an upper electrode 5 as shown in Fig. 1(g). Then, the resist is removed and the MIM device is completed.

Then, ITO is sputtered as shown in Fig. 1 (h) and etched in a way similar to that in (g), thereby forming a picture element electrode 6 connected to the Cr of electrode 5.

Fig. 2 is a plan view illustrating one embodiment of a MIM device fabricated through the steps shown in Fig. 1.

Fig. 3 is a cross sectional view taken along line A-A' of Fig. 2.

Fig. 4 shows the relationship between the contrast at a normal temperature of the normally white mode display MIM panel and the ratio between the device capacitance and the capacitance of the picture element of liquid crystal. The capacitance ratio is varied by changing the relative dielectric constant ($\varepsilon$) of the MIM's insulator by varying the amount of N added to the lower electrode Ta while keeping the film thickness of the insulator constant.

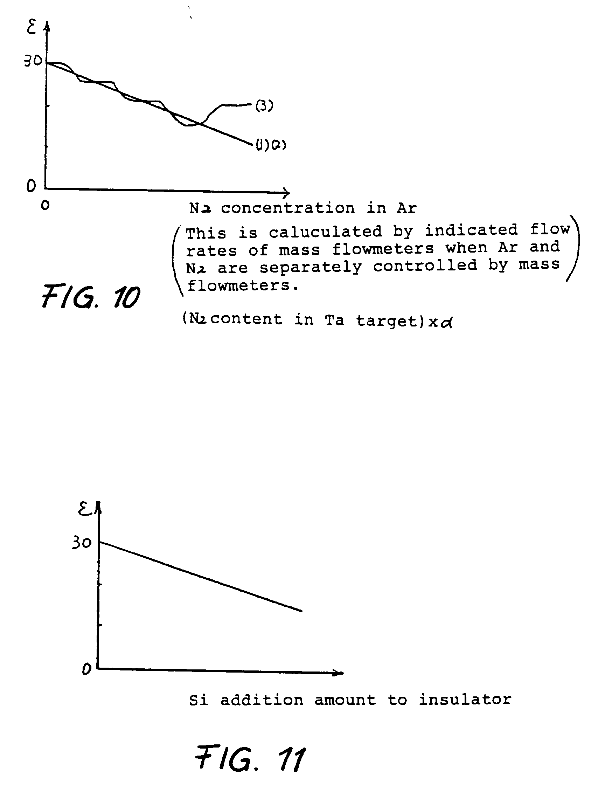

Usually, the $\varepsilon$ value of TaOx is about 30 but, since no appropriate capacitance ratio is set (about 1.6 as described), the contrast is as low as 50 - 60. However, the contrast is improved and then saturated along with the reduction of $\varepsilon$. Figs. 10 and Fig. 11 show the stability in the method of reducing $\varepsilon$. In the method according to Fig. 10-(1), a gas is introduced from an Ar-N$_2$ gas mixture cylinder adjusted to an optional concentration into a sputter chamber for sputtering. The method according to Fig. 10-(3) is different from that of Fig. 10-(1) in that Ar and N$_2$ are separately controlled for the flow rate by mass flowmeters and introduced and mixed in the sputtering chamber for sputtering, without using the gas mixture cylinder. In the method according to Fig. 10-(2), the sputtering gas is composed only of Ar, but an N-added Ta target is used. As can be seen from Fig. 10, delicate control for the concentration of sputtered N$_2$ by the mass flowmeter is difficult and lacks in reproducibility. On the other hand, it can be seen that the method of using the gas mixture cylinder or the N-Ta target is excellent since the reduction of $\varepsilon$ is proportional to the increase of the N$_2$ concentration. It has also been examined a method of adding N into TaOx by an N-plasma treatment after forming usual anodized TaOx without adding N. In this case there has been a problem that the dependency on the polarity of the device I-V characteristic is increased. However, since this method has a merit that the $\varepsilon$ value is reduced, the $\beta$ value is remarkably increased and the resistance of the electrode Ta is not increased, a device of satisfactory characteristic can be obtained by cancelling the dependency on the polarity with Ta/N - TaOx/Cr/Ta/N - TaOx/Cr in which two MIM devices are connected in series. Further, in case of Si addition shown in Fig. 11, Si-added Ta is sputtered and then anodized by a chip-on-target method of placing an Si chip on a Ta target and the characteristic is stable. The device characteristic upon improvement of the contrast was: $\beta^+ \geqq 4.0$ ($\beta^- \geqq 3.2$) ($\beta^+/\beta^-$ is the $\beta$ value when a positive/negative voltage is applied to the lower electrode Ta) at room temperature and $\beta^+ \geqq 3.5$ ($\beta^- \geqq 2.7$) at 60°C and R(3V) greater than $3 \times 10^{11}$ ohm at a normal temperature and greater than $10^{10}$ ohm at 60°C as shown in Figs. 6 and 7. Further, upon analysis by Auger and ESCA, the N-concentration in the electrode Ta was 5 - 45 at% and in the insulator 5 - 25 at%. Higher N-concentration can provide further improvement of the image quality but it increases instability of the device characteristic. The N-concentration of the N-added Ta target for satisfying the condition was 5 - 50 at%. Further, the crystal structure of the lower electrode Ta was $\alpha$-Ta or
$\alpha$-Ta+$Ta_2$N. The resistivity was less than 300 $\mu\Omega$cm. It was further found by ESCA analysis that the insulator structure contains oxynitride of TaOxNy. In the region of a lower N-addition amount, the content of TaOxNy was lower and the TaO content was higher, whereas in a region of an appropriate N-addition amount and with satisfactory characteristics of $\beta$, temperature characteristic of $\beta$ and R(3V), it consisted only of TaOxNy. It is considered that while a great number of movable Ta ions are present due to a lack of oxygen in a usual anodized film (presence is shown by TaO described above), they are converted into TaOxNy by the introduction of N and the movable ions are fixed to improve $\beta$, R(3v), etc.

Further, if the polarity difference of the I-V characteristic of the device is not within a range:

$$\mid \text{Log(I/V)}^- - \text{Log(I/V)}^+ \mid \, \leqq 0.2$$

flicker occurred but it could be adjusted by a heat treatment (at 250°C) after forming the device.

It was found that the scattering of the film quality within the plane of the substrate (containing an addition amount) was greatly improved when RF bias was applied to the substrate upon sputtering N-added, Si-added Ta. It is considered that the addition amount of N and Si is greater at the rotation center of the substrate when the bias is not applied, since the plasma density is higher at the center of the substrate. It is, however, considered that since the plasma density is increased at the peripheral portion of the substrate by the RF bias application, scattering within the plane is decreased.

Further, the MIM's insulator is formed by anodization in this embodiment, since it can provide preferred stability of the film quality and film thickness. In particular, in a case where different kinds of elements are added as in this embodiment, their stability greatly contributes to the production yield. If the anodization film is formed by thermal oxidation or reactive sputtering, the film stability is worsened at present, but this enables a complete dry production process to remarkably improve production throughput by means of the in-line system.

In this embodiment, different elements are also added to the lower electrode Ta except for the N-plasma treatment to increase the lower electrode resistance. Then, we have made a study on a method of applying sputtering while adding a slight amount of N in the sputtering atmosphere upon forming the portion other than the insulator into a film, thereby forming $\alpha$-Ta to reduce the resistance, and the size of the insulator can be increased to more than 20 inch.

In the present embodiment, normally white mode display is employed, which is enabled by the use of a color filter with overlying electrodes formed by flattening the color filter layer with an Si-modified polyimide and then forming thereover a transparent ITO conductive film (Fig. 8). However, if a method of applying ITO wirings on a substrate and forming a pigment film by a micell electrolysis thereover is used, normally white mode display is enabled with an easy underlying electrode structure without great reduction of the liquid crystal application voltage since the pigment has a low $\epsilon$ value and due to the presence of gaps between the pigments. The contrast is quite the same as that of the color filter with an overlying electrode. It has also been found that the contrast and the temperature characteristic of the contrast can be improved without normally white mode display.

Example-2

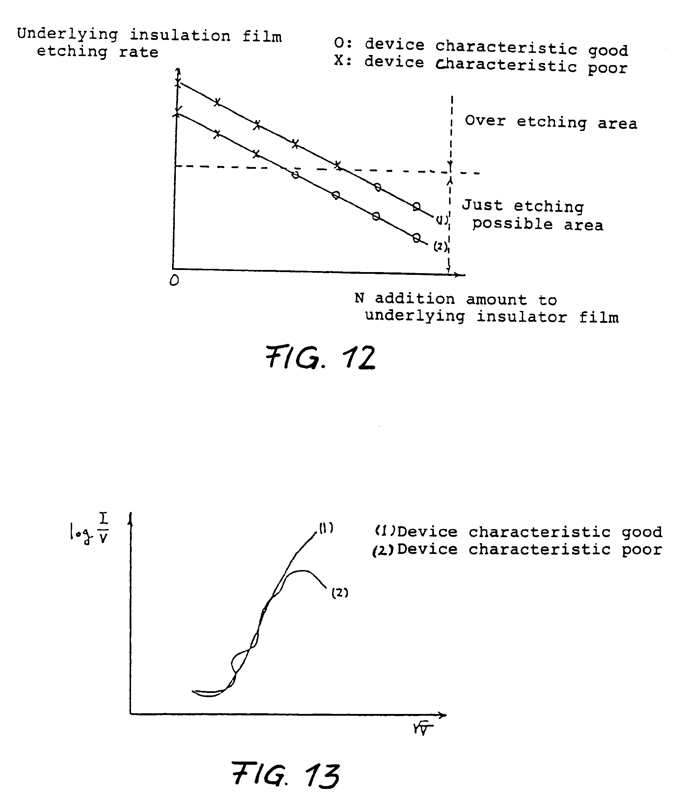

A MIM device in which N is added to the insulator shows an abnormal I-V characteristic as in Fig. 13-(2) if N is not added or only a little is added to the underlying TaOx film. However, if N is added by an amount greater than a predetermined level to the underlying substrate, the device I-V characteristic recovers to normal property as shown in Fig. 12 (Fig. 13-(1)). It is considered that since a thermally oxidized underlying film (Fig. 13-(2)) can provide a normal device with less an amount of N-addition than a reactive sputtered underlying film (Fig. 13-(1)), if the etching rate is high, etching is applied as far as the substrate upon dry etching of the lower electrode Ta to cause micro-cracks in the substrate, which increases the absorption of the water content in addition to the unevenness of the insulator described above, thus making the device characteristic abnormal.

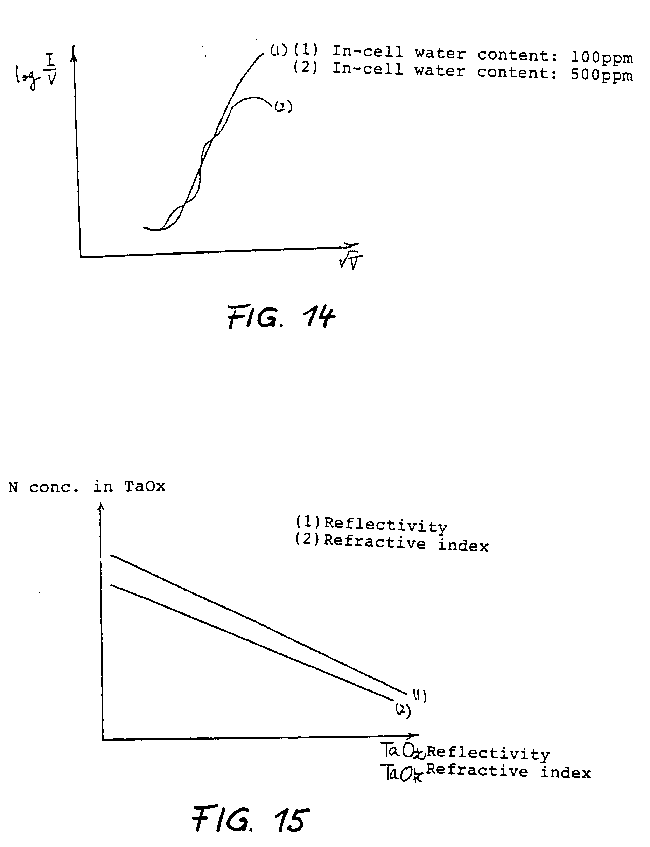

It is further considered that unevenness is increased also on the surface of the N-added insulator to increase the adsorption of the water content. It is, accordingly, important to apply such a dry etching technique as not to remove the underlying layer to expose the substrate in order to prevent adsorption of more water content, and the control of the water content in the panel cell is also important. The relationship between the water content in the cell and the N-added MIM device characteristic is shown in Fig. 14. It can be seen that if the water content in the cell is 100 ppm or less than 100 ppm, the device characteristic becomes stabilized.

Further, the underlying insulation film of oxides, nitrides and oxynitrides of Al, Si, Cr, Be or Mg described above is satisfactory like the TaOx underlying insulation film with addition of an appropriate amount of N.

Further, N concentration in the device insulator TaOx can be determined as an absolute amount by measuring the refractive index with an ellipsometer and evaluating the reflectivity by a spectrophotometer, which is shown in Fig. 15. This can instantly feedback the fluctuation of the production conditions to the sputtering to greatly improve the production yield. Further, not only the N-addition to TaOx but also other element concentration in other insulation films can also be controlled by the same method.

Example-3

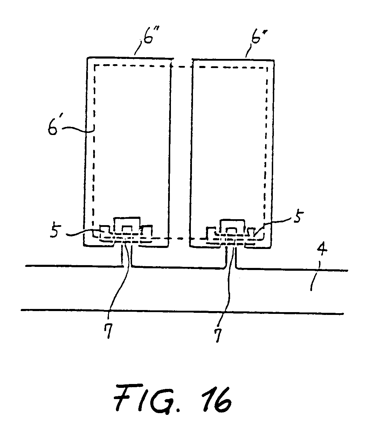

This example is shown in Fig. 16. Upon sputtering the lower electrode Ta, an Ar atmosphere is usually employed. When 12% of $N_2$ is mixed to the atmosphere, the relative dielectric constant of the device insulation film is reduced to one-half as compared with the case of not mixing $N_2$. It is considered that N is introduced into the TaOx film to increase TaOxNy or make the film to be composed only of TaOxNy.

Then, an N-doped MIM device sputtered with Ta by using 12% $N_2$-Ar atmosphere is prepared as shown in Fig. 16. In Fig. 16, 4 designates the insulator on the lower electrode 3 shown in Fig. 1, 5 the upper electrodes of the MIM devices 7, 6′ the shape of a concentional picture element electrode and 6″ the bisected picture element electrodes.

Since the device capacitance is one-half of the conventional device, the picture element is bisected to provide redundancy. When a normally black mode display liquid crystal panel was assembled by using the MIM substrate to examine the optical characteristic, the panel contrast was increased by about 20 to 30% as compared with the usual case. This is considered to be attributable to the reduction of the device capacitance due to the N-doping, as well as increase of the $\beta$ value showing the non-linearity of the device I-V characteristic ($I \propto V \exp (\beta \sqrt{V})$) by about 20%. Further, when spot defects were examined upon lighting up the panels although the defects were recognized, they caused no practical problem and the yield of 100 panels was 98%. The high yield is attributable to the fact that there is little probability that both of the bisected picture elements become defective and defects cannot be recognized easily when only one of the elements is normal and the other of them is defective. It is further possible to increase the number of division of picture elements to 4 or greater by further increasing the amount of N-doping and lowering the device capacitance, in which case defects were not recognized at all.

Then, a MIM device with the device capacitance reduced to one-half by placing a required number of Si chips on the Ta target instead of N-addition was prepared as shown in Fig. 16. Since the device capacitance is one-half of the conventional device, the picture elements were also bisected to provide redundancy. When the normally black mode display liquid crystal panel was assembled by using the MIM substrate to examine the optical characteristic, the contrast was quite identical with that of the usual MIM panel not undergoing picture element division. It is considered that since the capacitance ratio between the device and the liquid crystal is kept constant and there is no change of the device I-V characteristic due to the Si addition. Further, when spot defects were examined upon lighting up the panel, although the defects were recognized they caused no practical problem and the yield of 100 panels was 98%. This high yield is attributable to the fact there is little probability that both of the bisected picture elements become defective and a defects cannot be recognized easily if only one of the elements is normal and the other of them is defective. It was, however, possible to increase the number of division of picture elements to 4 or greater by further increasing the of Si-doping amount and lowering the device capacitance, in which case defects were not recognized at all.

Example-4

The fundamental production process for this embodiment is shown in Fig. 1. After sputtering a Ta film on a substrate made of Ba borosilicate glass to 40 nm thickness in a nitrogen-containing atmosphere by reactive sputtering, the Ta film was thermally oxidized at 500°C in an atmospheric air to form an underlying insulation film.

Then, a Ta film was formed on the underlying insulation film in a nitrogen-containing atmosphere to a thickness of 350 nm by reactive sputtering and to the thus formed Ta film was applied a chemical dry etching in

$CF_4+O_2$ thereby performing a pattern etching into a lower electrode.

Then, after anodizing the pattern-etched Ta film in an aqueous 1% solution of citric acid to form an insulation film of 60 nm thickness (insulator), a Cr film was formed to 150 nm thickness on the thus formed insulation film, which was then patterned by etching into an upper electrode, to form a MIM device.

Then, an ITO film was formed, which was etched to prepare a picture element electrode. In this case, the amount of N added to the lower electrode Ta was changed by varying the $N_2$ concentration in the sputtering atmosphere thereby varying the relative dielectric constant of the MIM device insulator below 30. Then, a panel for normally white mode display was prepared by combining the MIM device substrate and an overlying electrode color filter substrate. The relationship between the panel contrast and the capacitance ratio of the MIM device to the picture element liquid crystal is shown in Fig. 4. Fig. 4 also shows the crystal structure of the lower electrode Ta and the resistivity in this case.

The result of measurements are shown in Figs. 5 to 7 which have been described already above.

Example-5

A glass substrate (7059, Ba borosilicate glass, manufactured by Corning Co.) was cleaned and then sputtered with Ta in an $N_2$-containing atmosphere. Then, it was thermally oxidized to form an underlying insulation film. A Ta film for the lower electrode was further formed on the underlying insulation film. The sputtering was performed under the condition of: $1.5 \times 10^{-2}$ Torr (2 Pa) of gas pressure and 1.5 kW power. The sputtering gas comprised Ar+$N_2$. The gas partial pressure for each of $N_2$ and Ar was 3% and 97% respectively. The film thickness was set to 250 nm. Further, in an identical chamber, a Ta film was continuously sputtered to 50 nm thickness while controlling the $N_2$ gas partial pressure to 10% and Ar gas partial pressure to 90%.

Then, the Ta film was patterned to a predetermined size by photolithographic etching. There is no particular change in the etching property and etching was possible with $CF_4$ (60%) + $O_2$ (40%) gas with no troubles at all.

Then, an oxidized film was formed by an anodization method using an aqueous 1% solution of citric acid. It is considered that since a Ta nitride film is present in a thickness of 50 nm on the surface of the Ta sputtered film, it actually forms a composite insulation film of an oxynitride film.

Then, Cr was sputtered. The Ar pressure was $2 \times 10^{-2}$ Torr (2.7 Pa) and the power was 2 kW. The thickness was set to 150 nm. Cr was patterned to a predetermined size by using a wellknown photolithography technique. Further, ITO was formed by sputtering as a picture element electrode and then patterned to a predetermined size by photolithography. The thickness was 100 nm.

The resistivity of the lower electrode was measured to be $1.0 \times 10^{-4}$ Ωcm and it can be seen that the resistance is lowered by about 50 to 10% as compared with the usual case.

When the panel was assembled using the MIM substrate to confirm the image quality, a clear image quality was obtained with no so-called stain or unevenness of the image. Further, the effectiveness of the present invention can be confirmed in comparison with the case of a panel, in which the Ta electrode is made of TaN, and there is a difference in the image picture quality thus causing unevenness, between the areas nearer to and remote from the connection terminals of an external power supply.

Further, the crystal structure of the Ta electrode when sputtered under the foregoing sputtering conditions was confirmed by X-ray diffractometry. The peak X-ray diffraction was only the peak for α-Ta.

Example-6

A Ta film for the lower electrode was formed on a barium borosilicate glass 7059 manufactured by Corning Co. by using a sputtering device.

Ar (argon) and $N_2$ (nitrogen) gases were used as the sputtering gas. The total gas pressure was set to $2 \times 10^{-2}$ Torr (2.7 Pa) in which the $N_2$ gas was made to 0%, 2%, 5%, 10%, 15%, 20%, 25% and 28% respectively by the partial pressure. Heating was made at a constant temperature of 180°C. The sputtered film thickness was controlled to 280 nm in each of the cases by means of sputtering time. The sputtering power was set to 1.5 kW.

Then, the Ta film was patterned to a predetermined size using a known photolithographic etching technique. When etching was applied using a chemical dry etching device with 60% $CF_4$ and 40% $O_2$ gases there were no troubles at all.

Then, an oxidized film was formed by anodization using an aqueous 1% solution of citric acid. This constitutes an insulation film (I of a MIM device). Since the insulation film contains N, it actually constitutes an oxynitride film. When nitrogen in the oxynitride film was analyzed by an ion microanalyzer (IMA), optoelectronic analyzer (XPS) and Auger analyzer (AES), each of the contents was as shown in Table 1.

The thickness of the oxynitride film was set to 60 nm.

Then, Cr was sputtered while controlling the Ar pressure to 2 x 10$^{-2}$ Torr (2.7 Pa) and the power to 2 kW. The thickness was set to 150 nm. Cr was patterned to a predetermined size by using a well-known photolithographic etching technique. Further, ITO (Indium Tin Oxide) was formed by sputtering into a picture element electrode and then patterned to a predetermined size by photolithography. The thickness was set to 100 nm.

The size of the MIM device was 5 μm x 4 μm.

Table 1 shows the capacitance and the resistance of the MIM device under a voltage of 10 V, respectively. The capacitance was a value at 10 kHz, which was measured by using an LCR meter.

Further, a normally black mode display panel was assembled by using the MIM substrate and the contrast ratio was measured. The results are as shown in Table 1.

## Table 1

| N$_2$ sputter gas partial pressure | N content (at%) | | | Capacitance | Resistance (Ω) (10V) | Contrast ratio |
|---|---|---|---|---|---|---|
| | IMA | XPS | AES | | | |
| 0% | 0 | 0 | 0 | 3.8 nF/mm$^2$ | 2 x 10$^9$ | 1:30 |
| 2% | 3.2 | 3.0 | 3.1 | 3.7 nF/mm$^2$ | 4.5 x 10$^9$ | 1:35 |
| 5% | 5.3 | 5.6 | 6.3 | 3.2 nF/mm$^2$ | 5.3 x 10$^9$ | 1:60 |
| 10% | 7.8 | 8.3 | 8.7 | 2.5 nF/mm$^2$ | 5.6 x 10$^9$ | 1:70 |
| 15% | 14.7 | 13.2 | 14.6 | 2.0 nF/mm$^2$ | 6.1 x 10$^9$ | 1:80 |
| 20% | 21.2 | 20.8 | 19.7 | 1.5 nF/mm$^2$ | 6.3 x 10$^9$ | 1:90 |
| 25% | 23.6 | 22.4 | 24.1 | 1.0 nF/mm$^2$ | 6.5 x 10$^9$ | 1:95 |
| 28% | 28.3 | 26.4 | 28.5 | 0.5 nF/mm$^2$ | 3.2 x 10$^{10}$ | 1:35 |

As shown in Table 1, a MIM panel with an N amount of lower than 5 at% has no sufficient contrast ratio.

On the contrary, a MIM panel with an N amount of greater than 25 at% also has no sufficient contrast probably due to high resistance of the device and the resistivity of N-added Ta of greater than 300 μΩcm. The contrast can be improved by increasing the driving voltage, but this involves a problem of requiring special IC production or alternation of driving circuit, etc.

As can be seen from Table 1, MIM panels containing N by an amount from 5 at% to 25 at% show increased contrast.

Example-7

N was sputtered to Ba borosilicate glass 7059, manufactured by Corning Co. by using Ta targets each containing N of 0 at%, 3 at%, 5 at%, 10 at%, 20 at%, 30 at%, 40 at%, 50 at%, 55 at% and 60 at%. Sputtering was applied at an Ar gas pressure of 2 x 10$^{-2}$ Torr (2.7 Pa), heating the substrate to a temperature of 150°C and a sputtering power of 1.5 kW. The Ta film constituting the lower electrode was examined for the crystal structure by X-ray diffractometry.

The results are shown in Table 2.

Table 2

| N in Ta target | Crystal structure |
|---|---|
| 0 at% N | $\beta$-Ta |
| 3 at% N | $\beta$-Ta |
| 5 at% N | $\alpha$-Ta |
| 10 at% N | $\alpha$-Ta + $Ta_2N$ |
| 20 at% N | $\alpha$-Ta + $Ta_2N$ |
| 30 at% N | $\alpha$-Ta + $Ta_2N$ |
| 40 at% N | $\alpha$-Ta + $Ta_2N$ |
| 50 at% N | $\alpha$-Ta + $Ta_2N$ |
| 55 at% N | TaN |
| 60 at% N | TaN |

As shown in Table 2, the crystal structure is stable within a range of N in the Ta target from 10 at% to 50 at%.

Then, the Ta film was formed to a predetermined size by known photolithographic etching and then anodized with an aqueous 1% solution of citric acid. It was confirmed that the insulators contained Ta oxynitride by XPS analysis except for those prepared from a Ta target with 0 at% of N. The thickness was confirmed to be about 60 nm by examining peaks for 0 while etching with IMA.

Then, Cr was sputtered and formed by photolithographic etching to a predetermined size and then ITO was formed as a picture element electrode in the same manner as in the prior art.

The capacitance was measured by using an LCR meter. Further, Table 3 shows the results of measuring the resistivity of the Ta film described above by means of a 4-terminal measuring method.

Table 3

| N content in Ta target | Capacitance | Resistivity |
|---|---|---|
| 0 at% N | 3.9 nF/mm² | 2.3 x 10⁻⁴ Ω cm |
| 3 at% N | 3.6 nF/mm² | 2.0 x 10⁻⁴ Ω cm |
| 5 at% N | 3.2 nF/mm² | 1.0 x 10⁻⁴ Ω cm |
| 10 at% N | 3.0 nF/mm² | 1.5 x 10⁻⁴ Ω cm |
| 20 at% N | 2.8 nF/mm² | 2.0 x 10⁻⁴ Ω cm |
| 30 at% N | 2.2 nF/mm² | 2.0 x 10⁻⁴ Ω cm |
| 40 at% N | 1.6 nF/mm² | 2.1 x 10⁻⁴ Ω cm |
| 50 at% N | 1.0 nF/mm² | 2.2 x 10⁻⁴ Ω cm |
| 55 at% N | 0.7 nF/mm² | 3.2 x 10⁻⁴ Ω cm |
| 60 at% N | 0.5 nF/mm² | 3.9 x 10⁻⁴ Ω cm |

The size of the MIM device was 5 $\mu$m x 4 $\mu$m and the thickness of the insulator was 60 nm.

A liquid crystal panel was completed by using the substrate. For comparison, the image quality was examined for an MIM panel obtained by sputtering Ta in an Ar+$N_2$ atmosphere in which the $N_2$ and the Ar partial pressure were controlled by a mass flow meter and then anodizing the same.

At first, the panel having an N content of 0 to 3 at% had a contrast ratio of 1 : 30, panels prepared by using Ta targets containing N within a range from 5 at% to 50 at% had the contrast ratios of 1:50, 1:70, 1:75, 1:80, 1:90 and 1:95 respectively. The panels prepared by using the Ta targets with an N content of 55 and 60 at% had a contrast ratio of 1:80 and 1:50, respectively. Further, a Ta-sputtered panel in Ar+$N_2$ had a contrast ratio of 1:100 but unevenness or stains were formed in the picture as a whole. That is, it is assumed that the device characteristics were varied, such that a uniform state of the device was not attained.

The panels prepared by using the Ta targets with 55 and 60 at% N contents showed a difference in the image quality between the areas nearer to and remote from the connection terminals of an external power supply thereby causing unevenness. This may be attributable to the fact that the resistivity was as high as greater than 300 $\mu\Omega$cm and no sufficient voltage was applied to the remote picture element due to the voltage drop.

Example-8

Ba borosilicate glass 7059, manufactured by Corning Co. was cleaned with hot sulfuric acid at 80°C and further washed with water. A Ta film was sputtered on 80 substrates using a sputtering device at an Ar gas partial pressure of 1.8 x $10^{-2}$ Torr (2.4 Pa) + $N_2$ gas partial pressure of 2 x $10^{-3}$ Torr (0.27 Pa). The thickness was set to 50 nm.

When it was observed by X-ray diffractometry, TaN, $Ta_2N$. etc. were confirmed.

Then, it was thermally oxidized at 430°C for 4 hours in atmospheric air. The glass substrate taken out from the furnace was transparent at a transmission of 90% and had quite satisfactory transparency. When analyzing by an opto-electronic analyzer (XPX), O, N and Ta were detected to confirm that an oxynitride film of Ta was formed.

Then, Ta for the lower electrode was formed by sputtering in an $N_2$-containing atmosphere and fabricated into a predetermined size by photolithographic etching. The etching was applied by using a CDE device (dry etching device) manufactured by Tokuda Seisakusho and controlling a gas comprising $CF_4$ (60%) + $O_2$ (40%) partial pressure to a flow rate of 350 SCCM.

When the distribution of N and Ta within the surface of the etched substrate was confirmed by XPS, N and Ta were uniformly confirmed like that upon forming the underlying film to find that all of the oxynitride Ta film of the underlying film was left. In the underlying Ta oxide film with no N-addition, Ta was not confirmed uniformly and there were areas in which the underlying part was left and other areas in which the underlying part was eliminated.

Then, the patterned Ta was formed into an insulation film (I of MIM) by anodization using an aqueous 1% solution of citric acid. The thickness of the oxide film was about 50 nm when measured by an ellipsometer.

Then, a Cr film was sputtered in the same manner as in the conventional case. The thickness was set to 150 nm. The Cr film was patterned to a predetermined size using a resist and then etching by using MPM-E30 manufactured by Moroboshi Ink Co. Then, ITO (Indium Tin Oxide) as the picture element electrode was formed by sputtering and then etching to a predetermined size with an aqueous 20% solution of sulfuric acid and hydrochloric acid by photolithography.

When the current-voltage characteristic of the MIM device portion in this embodiment was measured, the β value (the slant of the current value between 6V - 8V) was within the scattering range from 4.2 to 4.5 among each of the substrates.

There was no disconnection of Cr at the tapered portion and there was no yield reduction due to Cr disconnection.

Example-9

Ba borosilicate glass, 7059 manufactured by Corning Co. was cleaned with a hot sulfuric acid at 80°C and a Ta film was formed by sputtering using a sputtering device in a 15% $N_2$ - Ar atmosphere. When the Ta film was investigated by X-ray diffractometry, it was composed of Ta (α-structure) and $Ta_2N$. A usual Ta film consists of β structure Ta. When the resistivity was measured, the lower electrode according to the present invention had a resistivity of 2.2 x $10^{-4}$ Ωcm, while the lower electrode of the β structure had a value of 2.1 x $10^{-4}$ Ωcm.

Thus, it can be seen that the resistivity in the present invention is substantially the same as in the case with no N-addition.

Then, Ta was patterned to a predetermined size by photolithographic etching. The N-added Ta could be

etched with $CF_4$ (60%) + $O_2$ (40%) gas with no troubles at all.

Then, an oxide film (insulator) was formed by anodization using an aqueous 1% solution of citric acid. Since the oxide film contains N, it actually consists of N-added Ta oxide. Although the structure could not be confirmed by X-ray diffractometry since the structure was amorphous, binding energy peak illustrating the oxynitride was confirmed by XPS analysis. In addition, peaks for TaO and TaN were also present.

Then, Cr was sputtered to a thickness of 150 nm. The Cr film was patterned to a predetermined size using wellknown photolithographic etching. Further, ITO was formed by sputtering as a picture element electrode and then patterned to a predetermined size by photolithography. The film thickness was set to 100 nm.

The capacitance of the MIM device according to the present invention was measured by using an LCR meter at optional 100 points. It was already confirmed that the area of the device was 5 $\mu$m x 4 $\mu$m and the thickness of the Ta oxynitride was 60 nm by means of an ellipsometer.

As a result, the capacitance was 2.7 $nF/mm^2$, which was reduced to about 2/3 of 3.8 $nF/mm^2$ of a conventional MIM device.

A normally white mode display panel was assembled by using this panel to confirm the image quality. The contrast ratio was confirmed to be improved as 1:100, which was greater than 1:60 in the conventional case.

Further, when the N addition amount of the lower electrode was changed, the insulator structure was composed only of Ta oxynitride, in which the device property $\beta$ was as high as 5 and the panel contrast was also as high as 150:1.

Further, a panel in which the lower electrode was composed only of Ta nitride, (TaN) was also prepared to examine the image quality. The panel showed a difference in the image quality between the area nearer to and that remote from the connection terminals of an external power supply, thereby causing unevenness.

Example-10

Ba borosilicate glass 7059, manufactured Corning Co. was cleaned with hot sulfuric acid at 80°C. A Ta film was formed to a thickness of 280 nm on the substrate by using a sputtering device at an Ar gas pressure of 1.5 x $10^{-2}$ Torr (2 Pa) and with a power of 1.5 kW.

Then, the Ta film was patterned to a predetermined size using a well-known photolithographic etching technic. The size of the device portion was set to 5 $\mu$m in width.

Then, an oxide film was formed by anodization using an aqueous 1% solution of citric acid. The initial voltage was set to 32 V. The thickness of the oxide film, was 50 nm when confirmed with an ellipsometer.

The anodized substrate was charged into a plasma etching device (DEM451, manufactured by Nichiden Anerba Co.) and subjected to a plasma treatment at an $N_2$ gas pressure of 2 x $10^{-2}$ Torr (2.7 Pa). The power was set to 500 W at RF. When the substrate was analyzed by an opto-electronic analyzer, peaks for TaO and TaN and peaks for Ta oxynitrides were confirmed to demonstrate that the film was composed of N-added Ta oxide.

Then, Cr was sputtered at an Ar pressure of 2 x $10^{-2}$ Torr (2.7 Pa) and with a power of 2 kW. The thickness was set to 150 nm. The Cr film was patterned to a predetermined size (4 $\mu$m at the portion of MIM) by using a known lithographic etching method. Further, ITO was formed by sputtering as a picture element electrode and then patterned into a predetermined size by photolithography. The thickness was set to 100 nm.

When the current-voltage characteristics of the MIM device substrate was confirmed at optional 100 positions, the electrical current flowing upon application of 10 V voltage was from 2 x $10^{-9}$ A to 3.5 x $10^{-9}$ A. It can be seen that the deviation among the devices of the present invention is extremely reduced as compared with usual cases for the devices prepared by anodization by sputtering Ta in Ar gas + $N_2$ gas under respective flow rate control by a mass flow meter, in which the current-voltage characteristics varied from 5 x $10^{-8}$ A to 1 x $10^{-10}$ A.

Further, the $\beta$ value was extremely high and satisfactory ($\beta$=9). Since a polarity difference was present in the I-V characteristic, two MIM devices were connected in series to cancel the polarity difference.

In addition, the capacitance of the devices was within a range from 2.5 to 2.7 $nF/mm^2$ and it can be seen that the device characteristic is stable as compared with the case of oxynitride obtained by anodization using Ar+$N_2$ gas under mass flow control, in which the capacitance varied from 1.7 to 3.7 $nF/mm^2$.

When the panel was assembled into a display panel to confirm the image quality, a clear image quality was obtained with no so-called stain or unevenness in the image quality. Further, the effectiveness of the present invention can be confirmed in comparison with a panel having a lower electrode sputtered with Ar and $N_2$ gas showing difference in the image quality thus causing unevenness between areas near to and remote from connection terminals to an external power source. Only in a large sized substrate (for example of 300 mm square), scattering of the device characteristic occurred which may attributable to the scattering of the plasma density.

Example-11

Ba borosilicate glass 7059, manufactured by Corning Co. was cleaned with hot sulfuric acid at 80°C. An N-added TaOx film for the underlying film was put to active sputtering on a substrate by using a sputtering device. As a sputtering gas, 37 SCCM of a gas from a gas mixture cylinder comprising 15% $N_2$-Ar and 87 SCCM of a gas from a gas cylinder exclusively for $O_2$ were introduced into a flow rate control chamber. The film was sputtered to 60 nm by using a DC magnetron sputter at 2 kW and applied RF bias of 100 W to the substrate. Then , an N-Ta film for the lower electrode was formed to 350 nm thickness by using a gas mixture cylinder containing 15% $N_2$-Ar used for the underlying film. The flow rate of the sputtering gas was 60 SCCM. A DC magnetron sputter with 2 kW was used and RF bias of 100 W was applied to the substrate to be sputtered. The N-Ta film had a crystal structure of $\alpha$-Ta+$Ta_2$N and a resistivity of 220 $\mu\Omega$cm. Then, a predetermined pattern was formed by using a photoresist OFPR-800 and an N-Ta film was pattern-etched to the lower electrode by a chemical dry etching method. Chemical dry etching was applied by using a CDE device manufactured by Tokuda Seisakusho and controlling the flow rate of a gas comprising $CF_4$ (60%) + $O_2$ (40%) partial pressure to 350 SCCM. Then, the patterned substrate was immersed in an aqueous 1% solution of citric acid and anodized under a voltage of 32 V to form an insulation film as an MIM insu lator to a thickness of 60 nm. Then, a Cr film was formed to 150 nm thickness using a sputtering device. The Cr film was patterned to a predetermined size using a photoresist and etching by using MPM-E30 manufactured by Moroboshi Ink Co. into an upper electrode. Then, ITO was formed as a picture element electrode by sputtering to a thickness of 100 nm and etching to a predetermined size by using an aqueous 20% solution of nitric acid and hydrochloric acid using photolithography to prepare a substrate for an MIM device.

Then, dyed color filter layers R, G, B were formed each on Ba borosilicate glass, Pyrex 7059, manufactured by Corning Co., over which silicon-modified polyimide was coated and baked to flatten the color filter layers, as an opposed substrate. Then, ITO was further sputtered and pattern etched thereover to prepare wiring electrodes.

After immersing the thus obtained two substrates (MIM device substrate and color filter substrate) into an aqueous 0.1% solution of aminosilane SH6020 (manufactured by Nippon Soda Co.), they were cleaned and baked at 180°C and then subjected to rubbing for orientation treatment. The MIM device substrate and the color filter substrate were appended to each other using a thermosetting epoxy resin containing glass fibers of 6 $\mu$m diameter as the sealing material, that is, a cell gap maintaining member, and press bonded at 150°C for 3 hours to obtain a liquid crystal cell. A liquid crystal composition was sealed in the liquid crystal cell by means of vacuum sealing. PCH (phenyl cyclohexane) liquid crystal ZLI-1695, manufactured by Merck Co. was used as the liquid crystal composition.

A liquid crystal display panel was completed by appending a polarization plate on each of the upper and lower surfaces of the liquid crystal cell.

When the crystal display panel was driven at 1/480 duty, a contrast of higher than 100 could be obtained within a temperature range from room temperature to 60°C.

As has been described above, in an active matrix type liquid crystal display device comprising a plurality of row electrodes disposed on a first substrate and a plurality of column electrodes disposed on an opposed second substrate perpendicularly to the row electrodes, and non-linear switching resistance elements each disposed between each picture element portion formed in a matrix-like pattern at each intersection between both of the electrodes and in which a liquid crystal sealed between both of the substrates is electrically driven to conduct display, a 2-terminal MIM device (Metal-Insulator Metal) is used as the non-linear resistance device. The relative dielectric constant $\varepsilon$ of the insulator is less than that of TaOx (in which x represents an optional number), and the capacitance $C_{CF}$ of the second substrate, capacitance $C_{LC}$ of liquid crystal in the picture element portion and the capacitance $C_{MIM}$ of the MIM device have a relationship:

$$C_{CF} \times C_{LC}/((C_{CF} + C_{LC}) \times C_{MIM}) > 2$$

Further, a method of manufacturing the active matrix type liquid crystal display device as described above, comprises a first step of reactive-sputtering a Ta film on the substrate in a nitrogen-containing atmosphere and then oxidizing the Ta film to form an underlying insulation film, a second step of reactive sputtering a Ta film on the underlying insulation film in a nitrogen containing atmosphere, a third step of pattern etching the Ta film formed in the second step thereby forming a lower electrode, a fourth step of oxidizing the pattern etched Ta film into an insulation film (insulator), a fifth step of forming a Cr film on the insulation film formed in the fourth step, a sixth step of pattern etching the Cr film formed in the fifth step into an upper electrode thereby forming a MIM device, a seventh step of forming an ITO film after the sixth step and an eighth step of etching the ITO film into a picture element electrode. Accordingly, the picture quality of an MIM display which has been inferior so far to a TFT liquid crystal display can be remarkably increased or improved to be equal or superior to that of the TFT. In addition, by the redundant design involving as division of each picture element, it is possible to remarkably increase the production yield, make the difference in the production costs relative to that of a TFT device even greater, which had no substantial change in recent years, and attain the production yield inherent to 2-terminal devices. Further, production of a small sized display of about one inch size, which has been considered impossible so far has now been enabled. Further, a resistivity as low as 60 $\mu\Omega$cm can be realized to attain the possibility of an application to large-sized displays of greater than 20 inch by controlling the crystal structure of the lower electrode. A MIM device considered so far to be suitable to a large-sized display can be actually realized, for the first time, by attaining the redundant design, reduction of resistance of the wirings, rapid feedback of the insulator film quality to the sputtering conditions, etc.

## Claims

1. An active matrix type liquid crystal display device comprising a plurality of row electrodes disposed on a first substrate, a plurality of column electrodes intersecting said row electrodes and disposed on an opposed second substrate, a plurality of MIM elements formed on one of said substrates each in a respective one of picture element portions defined in a matrix-like pattern at the intersections between both of said electrodes, and a liquid crystal sealed between said substrates which is electrically driven for display, wherein an underlying insulating layer doped with N is provided on said one substrate and wherein the capacitance of the second substrate $C_{CF}$, the capacitance of the liquid crystal portion of one picture element portion $C_{LC}$ and the capacitance of the MIM element ($C_{MIM}$) have the following relationship:
$$C_{CF} \times C_{LC}/((C_{CF} + C_{LC}) \times C_{MIM}) > 2$$

2. A display device as defined in claim 1, wherein the second substrate has a color filter layer underlying electrodes and $C_{CF}$ is the capacitance of said color filter layer.

3. A display device as defined in claim 1, wherein the second substrate has a color filter layer overlying electrodes and $C_{CF} = \infty$.

4. A display device as defined in claim 1, wherein the driving method for the active matrix type liquid crystal display device is either normally black or normally white mode displaying.

5. A display device as defined in claim 1, wherein the concentration of the water content in the liquid crystal is less than 100 ppm.

6. A display device as defined in claim 1, wherein the MIM 2-terminal device comprises Ta/TaOx/Cr (lower electrode metal/insulator/upper electrode metal) and other elements are added to TaOx, the underlying insulation film being of an oxide doped with N, nitride or oxynitride.

7. A display device as defined in claim 6, wherein the relative dielectric constant of TaOx to which other elements are added is 22 or less than 22.

8. A display device as defined in claim 6, wherein the relative dielectric constant of TaOx to which other elements are added is 10 or less than 10.

9. A display device as defined in any of claims 6 to 8, wherein N or Si is added to TaOx.

10. A display device as defined in any of claims 6 to 8, wherein the added element is added in the form of an oxide, nitride or oxynitride.

11. A display device as defined in claim 6, wherein the crystal structure of the lower electrode Ta used for the MIM 2-terminal device is $\alpha$-Ta.

12. A display device as defined in claim 9, wherein the concentration of added N is from 5 to 25 at%.

13. A display device as defined in claim 9, wherein 5 to 45 at% of N is contained in the lower electrode Ta of the MIM 2-terminal device.

14. A display device as defined in claim 13, wherein the crystal structure of the lower electrode Ta is $\alpha$-Ta or

a mixture of $\alpha$-Ta and $Ta_2N$.

15. A display device as defined in claim 14, wherein the resistivity of the N-added lower electrode Ta is from 60 to 300 $\mu\Omega$cm.

16. A display device as defined in claim 6, wherein the oxynitride film formed on the substrate is Ta oxynitride.

17. A display device as defined in claim 9, wherein Ta oxynitride (TaOxNy in which x and y each represents an optional number) is present in the N-added TaOx film.

18. A display device as defined in any of claims 6 to 16, wherein each one of the picture element electrodes, at the intersections between the row electrodes and the column electrodes, is divided into a plurality of sections, to each of which the MIM 2-terminal device in which other elements are added to TaOx is connected.

19. A method of manufacturing an active matrix type liquid crystal display device comprising a plurality of row electrodes disposed on a first substrate, a plurality of column electrodes intersecting said row electrodes and disposed on an opposed second substrate and non-linear switching resistance elements each disposed in a picture element portion formed in a matrix-like pattern at each intersection between both of said electrodes, in which liquid crystals sealed between said substrates are electrically driven for display, wherein the method comprises:

a first step of applying reactive sputtering to form a Ta film on a substrate in a nitrogen-containing atmosphere and then oxidizing Ta film to form an underlying insulation film,

a second step of applying reactive sputtering to form a Ta film on said underlying insulation film in a nitrogen-containing atmosphere,

a third step of pattern etching the Ta film formed in the second step to form a lower electrode,

a fourth step of oxidizing the pattern etched Ta film into an insulation film (insulator),

a fifth step of forming a Cr film on the insulation film formed in the fourth step,

a sixth step of pattern etching the Cr film formed in the fifth step to prepare an upper electrode thereby forming a MIM device,

a seventh step of forming an ITO film after the sixth step, and

an eighth step of etching the ITO film into a picture element electrode.

20. A method as defined in claim 19, wherein the oxidization method in the first or the fourth step is thermal oxidization or anodic oxidization.

21. A method as defined in claim 19, wherein the insulation film in the first step and/or the insulator in the fourth step is formed by reactive sputtering.

22. A method as defined in claim 19, wherein Ar is contained in the nitrogen-containing atmosphere in the first and/or the second step.

23. A method as defined in claim 19, wherein a Ta target containing 5 to 50 at% of N is sputtered in an atmosphere not containing nitrogen in the first and the second step instead of a nitrogen-containing atmosphere.

24. A method as defined in claim 19, wherein sputtering is applied while applying RF bias to the substrate in the second step.

25. A method as defined in claim 19, wherein N is added to the insulation film and/or the insulator in the first or the second step by N-plasma treatment after oxidation or after reactive sputtering.


**Patentansprüche**

1. Flüssigkristall-Anzeigevorrichtung mit aktiver Matrix, umfassend eine Mehrzahl von auf einem ersten Substrat angeordneten Zeilenelektroden, eine Mehrzahl von Spaltenelektroden, die die Zeilenelektroden schneiden und auf einem gegenüberliegenden zweiten Substrat angeordnet sind, eine Mehrzahl von MIM-Elementen, die auf einem der Substrate jeweils in einem von Bildelementbereichen, die in einem matrixähnlichen Muster an den Schnittpunkten zwischen den beiden genannten Elektroden definiert sind, gebildet sind, und einen zwischen den Substraten eingeschlossenen Flüssigkristall, der zur Anzeige elektrisch angesteuert wird, wobei eine untere, mit N dotierte Isolierschicht auf dem einem Substrat vorgesehen ist und wobei die Kapazität des zweiten Substrats $C_{CF}$, die Kapazität des Flüssigkristallbereichs eines Bildelementbereichs $C_{LC}$ und die Kapazität des MIM-Elements ($C_{MIM}$) die folgende Beziehung erfüllen:

$$C_{CF} \times C_{LC} / ((C_{CF} + C_{LC}) \times C_{MIM}) > 2$$

2. Anzeigevorrichtung nach Anspruch 1, bei der das zweite Substrat eine unter den Elektroden angeordnete Farbfilterschicht aufweist und $C_{CF}$ die Kapazität der Farbfilterschicht ist.

3. Anzeigevorrichtung nach Anspruch 1, bei der das zweite Substrat eine Farbfilterschicht über den Elektroden aufweist und $C_{CF} = \infty$.

4. Anzeigevorrichtung nach Anspruch 1, bei der es sich beim Ansteuerungsverfahren für die Flüssigkristall-Anzeigevorrichtung mit aktiver Matrix um eine im Normalzustand schwarze oder im Normalzustand weiße Anzeigeart handelt.

5. Anzeigevorrichtung nach Anspruch 1, bei der die Wasserkonzentration im Flüssigkristall weniger als 100 ppm beträgt.

6. Anzeigevorrichtung nach Anspruch 1, bei der die zweipolige MIM-Vorrichtung Ta/TaOx/Cr (untere Metallelektrode; Isolator; obere Metallelektrode) und andere dem TaOx zugesetzte Elemente umfaßt, wobei es sich bei der unteren Isolierschicht um ein mit N, Nitrid oder Oxynitrid dotiertes Oxid handelt.

7. Anzeigevorrichtung nach Anspruch 6, bei der die relative Dielektrizitätskonstante von TaOx, das mit anderen Elementen versetzt ist, 22 oder weniger als 22 beträgt.

8. Anzeigevorrichtung nach Anspruch 6, bei der die relative Dielektrizitätskonstante von TaOx, das mit anderen Elementen versetzt ist, 10 oder weniger als 10 beträgt.

9. Anzeigevorrichtung nach einem der Ansprüche 6 bis 8, bei der dem TaOx N oder Si zugesetzt ist.

10. Anzeigevorrichtung nach einem der Ansprüche 6 bis 8, bei der das zugesetzte Element in Form eines Oxids, Nitrids oder Oxynitrids zugesetzt ist.

11. Anzeigevorrichtung nach Anspruch 6, bei der die Kristallstruktur der unteren Ta-Elektrode für die 2-polige MIM-Vorrichtung in der $\alpha$-Ta-Form vorliegt.

12. Anzeigevorrichtung nach Anspruch 9, bei der die Konzentration des zugesetzten N 5 bis 25 Atom-% beträgt.

13. Anzeigevorrichtung nach Anspruch 9, bei der 5 bis 45 Atom-% N in der unteren Ta-Elektrode der 2-poligen MIM-Vorrichtung enthalten sind.

14. Anzeigevorrichtung nach Anspruch 13, bei der die Kristallstruktur der unteren Ta-Elektrode die $\alpha$-Ta-Form oder eine Mischform aus $\alpha$-Ta und Ta$_2$N aufweist.

15. Anzeigevorrichtung nach Anspruch 14, bei der der spezifische Widerstand der mit N versetzten unteren Ta-Elektrode 60 bis 300 $\mu\Omega$cm beträgt.

16. Anzeigevorrichtung nach Anspruch 6, bei der es sich bei der auf dem Substrat gebildeten Oxynitridschicht um Ta-oxynitrid handelt.

17. Anzeigevorrichtung nach Anspruch 9, bei der das Ta-oxynitrid (TaOxNy, worin x und y jeweils eine beliebige Zahl bedeuten) in der mit N versetzten TaOx-Schicht vorhanden ist.

18. Anzeigevorrichtung nach einem der Ansprüche 6 bis 16, bei der jede einzelne der Bildelementelektroden

EP 0 388 986 B1

an den Schnittpunkten zwischen den Zeilenelektroden und den Spaltenelektroden in eine Mehrzahl von Abschnitten unterteilt ist, mit denen jeweils die 2-polige MIM-Vorrichtung, in der andere Elemente dem TaOx zugesetzt sind, verbunden ist.

**19.** Verfahren zur Herstellung einer Flüssigkristall-Anzeigevorrichtung mit aktiver Matrix, umfassend eine Mehrzahl von auf einem ersten Substrat angeordneten Zeilenelektroden, eine Mehrzahl von Spaltenelektroden, die die Zeilenelektroden schneiden und auf einem gegenüberliegenden zweiten Substrat angeordnet sind, und nicht-lineare Schaltwiderstandselemente, die jeweils in einem Bildelementbereich, der in einem matrixähnlichen Muster an jedem Schnittpunkt zwischen den beiden Elektroden gebildet ist, angeordnet sind, wobei zwischen den Substraten eingeschlossene Flüssigkristalle zur Anzeige elektrisch angesteuert werden, wobei das Verfahren folgende Stufen umfaßt:

eine erste Stufe, bei der ein reaktives Sputtering zur Bildung einer Ta-Schicht auf einem Substrat in einer stickstoffhaltigen Atmosphäre durchgeführt wird und anschließend die Ta-Schicht unter Bildung einer unteren Isolierschicht oxidiert wird,

eine zweite Stufe, bei der ein reaktives Sputtering zur Bildung einer Ta-Schicht auf der unteren Isolierschicht in einer stickstoffhaltigen Atmosphäre durchgeführt wird,

eine dritte Stufe, bei der ein Muster in der in der zweiten Stufe gebildeten Ta-Schicht zur Bildung einer unteren Elektrode geätzt wird,

eine vierte Stufe, bei die zu dem Muster geätzte Ta-Schicht zu einer Isolierschicht (Isolator) oxidiert wird,

eine fünfte Stufe, bei der eine Cr-Schicht auf der in der vierten Stufe erzeugten Isolierschicht gebildet wird,

eine sechste Stufe, bei der ein Muster in der in der fünften Stufe erzeugten Cr-Schicht zur Bildung einer oberen Elektrode geätzt wird, wodurch man eine MIM-Vorrichtung erhält,

eine siebte Stufe, bei der eine ITO-Schicht nach der sechsten Stufe gebildet wird, und

eine achte Stufe, bei der die ITO-Schicht zu einer Bildelementelektrode geätzt wird.

**20.** Verfahren nach Anspruch 19, bei dem es sich beim Oxidationsverfahren in der ersten oder der vierten Stufe um eine thermische Oxidation oder anodische Oxidation handelt.

**21.** Verfahren nach Anspruch 19, bei dem die Isolierschicht in der ersten Stufe und/oder der Isolator in der vierten Stufe durch reaktives Sputtering gebildet werden.

**22.** Verfahren nach Anspruch 19, bei dem Ar in der stickstoffhaltigen Atmosphäre in der ersten und/oder der zweiten Stufe enthalten ist.

**23.** Verfahren nach Anspruch 19, bei dem ein Ta-Target mit einem Gehalt an 5 bis 50 Atom-% N in einer Atmosphäre ohne Stickstoff in der ersten und in der zweiten Stufe statt in einer stickstoffhaltigen Atmosphäre gesputtert wird.

**24.** Verfahren nach Anspruch 19, bei dem das Sputtering unter Anlegen einer RF-Vorspannung an das Substrat in der zweiten Stufe durchgeführt wird.

**25.** Verfahren nach Anspruch 19, bei dem N der Isolierschicht und/oder dem Isolator in der ersten oder in der zweiten Stufe durch N-Plasmabehandlung nach Oxidation oder reaktivem Sputtering zugesetzt wird.


**Revendications**

**1.** Un dispositif de visualisation à cristal liquide du type à matrice active, comprenant un ensemble d'électrodes de ligne disposées sur un premier substrat, un ensemble d'électrodes de colonne formant des intersections avec les électrodes de ligne et disposées sur un second substrat, opposé au premier, un ensemble d'éléments MIM formés sur l'un des substrats, chacun de ces éléments se trouvant dans l'une respective de parties d'éléments d'image qui sont définies avec une configuration matricielle aux intersections entre les deux sortes d'électrodes, et un cristal liquide enfermé de façon étanche entre les substrats, qui est attaqué électriquement pour la visualisation, dans lequel une couche isolante sous-jacente, dopée avec N, est formée sur le premier substrat, et dans lequel la capacité du second substrat $C_{CF}$, la capacité de la partie de cristal liquide d'une partie d'élément d'image $C_{LC}$ et la capacité de l'élément MIM

17

($C_{MIM}$) présentent la relation suivante :

$$C_{CF} \times C_{LC}/((C_{CF} + C_{LC}) \times C_{MIM}) > 2$$

2. Un dispositif de visualisation défini dans la revendication 1, dans lequel le second substrat comporte une couche de filtre de couleur située au-dessous des électrodes, et $C_{CF}$ est la capacité de cette couche de filtre de couleur.

3. Un dispositif de visualisation défini dans la revendication 1, dans lequel le second substrat comporte une couche de filtre de couleur située au-dessus des électrodes, et $C_{CF} = \infty$.

4. Un dispositif de visualisation défini dans la revendication 1, dans lequel le procédé d'attaque pour le dispositif de visualisation à cristal liquide du type à matrice active est la visualisation dans le mode de noir à l'état inactif ou dans le mode de blanc à l'état inactif.

5. Un dispositif de visualisation défini dans la revendication 1, dans lequel la concentration d'eau dans le cristal liquide est inférieure à 100 ppm.

6. Un dispositif de visualisation défini dans la revendication 1, dans lequel le dispositif MIM à 2 bornes a une structure Ta/TaOx/Cr (métal de l'électrode inférieure/isolant/métal de l'électrode supérieure), et d'autres éléments sont ajoutés à TaOx, la pellicule d'isolation sous-jacente consistant en un oxyde dopé avec N, en un nitrure ou en un oxynitrure.

7. Un dispositif de visualisation défini dans la revendication 6, dans lequel la constante diélectrique relative de TaOx auquel d'autres éléments sont ajoutés est égale à 22 ou inférieure à 22.

8. Un dispositif de visualisation défini dans la revendication 6, dans lequel la constante diélectrique relative de TaOx auquel d'autres éléments sont ajoutés est égale à 10 ou inférieure à 10.

9. Un dispositif de visualisation défini dans l'une quelconque des revendications 6 à 8, dans lequel N ou Si est ajouté à TaOx.

10. Un dispositif de visualisation défini dans l'une quelconque des revendications 6 à 8, dans lequel l'élément ajouté est ajouté sous la forme d'un oxyde, d'un nitrure ou d'un oxynitrure.

11. Un dispositif de visualisation défini dans la revendication 6, dans lequel la structure cristalline du Ta de l'électrode inférieure qui est utilisé pour le dispositif MIM à 2 bornes est la structure $\alpha$- Ta.

12. Un dispositif de visualisation défini dans la revendication 9, dans lequel la concentration de N ajouté correspond à un pourcentage atomique allant de 5 à 25%.

13. Un dispositif de visualisation défini dans la revendication 9, dans lequel le Ta de l'électrode inférieure du dispositif MIM à 2 bornes contient un pourcentage atomique de N qui va de 5 à 45%.

14. Un dispositif de visualisation défini dans la revendication 13, dans lequel la structure cristalline du Ta de l'électrode inférieure est la structure $\alpha$-Ta ou un mélange de $\alpha$-Ta et $Ta_2N$.

15. Un dispositif de visualisation défini dans la revendication 14, dans lequel la résistivité du Ta de l'électrode inférieure avec ajout de N est comprise entre 60 et 300 $\mu\Omega$cm.

16. Un dispositif de visualisation défini dans la revendication 6, dans lequel la pellicule d'oxynitrure qui est formée sur le substrat consiste en oxynitrure de Ta.

17. Un dispositif de visualisation défini dans la revendication 9, dans lequel de l'oxynitrure de Ta (TaOxNy, x et y représentant chacun un nombre choisi comme on le désire) est présent dans la pellicule de TaOx avec ajout de N.

18. Un dispositif de visualisation défini dans l'une quelconque des revendications 6 à 16, dans lequel aux intersections entre les électrodes de ligne et les électrodes de colonne, chacune des électrodes d'élément d'image est divisée en un ensemble de sections, à chacune desquelles est connecté le dispositif MIM à 2 bornes dans lequel d'autres éléments sont ajoutés à TaOx.

19. Un procédé de fabrication d'un dispositif de visualisation à cristal liquide du type à matrice active comprenant un ensemble d'électrodes de ligne disposées sur un premier substrat, un ensemble d'électrodes de colonne formant des intersections avec les électrodes de ligne et disposées sur un second substrat, opposé au premier, et des éléments de commutation à résistance non linéaire, chacun d'eux étant disposé dans une partie d'élément d'image qui est formée avec une configuration matricielle à chaque intersection entre les deux sortes d'électrodes, dans lequel des cristaux liquides enfermés de façon étanche entre les substrats sont attaqués électriquement pour la visualisation, ce procédé comprenant :
une première étape d'application de pulvérisation cathodique réactive pour former une pellicule de Ta sur un substrat, dans une atmosphère contenant de l'azote, et ensuite d'oxydation de la pellicule de Ta pour former une pellicule d'isolation sous-jacente,
une seconde étape d'application de pulvérisation cathodique réactive pour former une pellicule de Ta sur la pellicule d'isolation sous-jacente, dans une atmosphère contenant de l'azote,
une troisième étape de définition d'un motif par attaque de la pellicule de Ta qui est formée au cours de la seconde étape, pour former une électrode inférieure,
une quatrième étape d'oxydation de la pellicule de Ta dans laquelle un motif a été formé par attaque, pour donner une pellicule d'isolation (isolant)
une cinquième étape de formation d'une pellicule de Cr sur la pellicule d'isolation qui est formée au cours de la quatrième étape,
une sixième étape de définition d'un motif par attaque de la pellicule de Cr qui est formée à la cinquième étape, pour préparer une électrode supérieure et former ainsi un dispositif MIM,
une septième étape de formation d'une pellicule d'ITO après la sixième étape, et
une huitième étape d'attaque de la pellicule d'ITO pour former une électrode d'élément d'image.

20. Un procédé défini dans la revendication 19, dans lequel le procédé d'oxydation qui est employé à la première ou à la quatrième étape est une oxydation thermique ou une oxydation anodique.

21. Un procédé défini dans la revendication 19, dans lequel la pellicule d'isolation à la première étape et/ou l'isolant à la quatrième étape est formé par pulvérisation cathodique réactive.

22. Un procédé défini dans la revendication 19, dans lequel l'atmosphère contenant de l'azote qui est utilisée à la première et/ou à la seconde étape contient Ar.

23. Un procédé défini dans la revendication 19, dans lequel une cible en Ta contenant un pourcentage atomique de 5 à 50% de N est soumise à une opération de pulvérisation cathodique dans une atmosphère ne contenant pas d'azote à la première étape et à la seconde étape, au lieu d'une atmosphère contenant de l'azote.

24. Un procédé défini dans la revendication 19, dans lequel la pulvérisation cathodique est accomplie pendant l'application d'une polarisation RF au substrat au cours de la seconde étape.

25. Un procédé défini dans la revendication 19, dans lequel N est ajouté à la pellicule d'isolation et/ou à l'isolant à la première étape ou à la seconde étape, par un traitement par un plasma de N, après oxydation ou après pulvérisation cathodique réactive.

First step

| Formation of underlying insulation film |

Second step

| Formation of N-Ta film |

Third step

| Formation of lower electrode |

Fourth step

| Formation of insulator |

Fifth step

| Formation of Cr film |

Sixth step

| Formation of upper electrode |

Seventh step

| Formation of ITO |

Eighth step

| Formation of picture element electrode |

(a)

(b)

(c)

(d)

(e)

(f)

(g)

(h)

(i)

FIG. 1

20

FIG. 2

FIG. 3

Contrast

FIG. 4

Contrast

FIG. 5

FIG. 6

FIG. 7

FIG. 8

FIG. 9

**FIG. 10**

N₂ concentration in Ar

$\left(\begin{array}{l}\text{This is caluculated by indicated flow}\\ \text{rates of mass flowmeters when Ar and}\\ \text{N}_2 \text{ are separately controlled by mass}\\ \text{flowmeters.}\end{array}\right)$

(N₂ content in Ta target)x$\alpha$

Si addition amount to insulator

**FIG. 11**

Underlying insulation film
etching rate

O: device characteristic good
X: device characteristic poor

Over etching area

Just etching
possible area

N addition amount to
underlying insulator film

## FIG. 12

$\log \dfrac{I}{V}$

(1) Device characteristic good
(2) Device characteristic poor

$\sqrt{V}$

## FIG. 13

$\log \dfrac{I}{V}$

(1) (1) In-cell water content: 100ppm
(2) In-cell water content: 500ppm

(2)

$\sqrt{V}$

FIG. 14

N conc. in TaOx

(1) Reflectivity
(2) Refractive index

(1)
(2)

$TaO_x$ Reflectivity
$TaO_x$ Refractive index

FIG. 15

FIG. 16